(19) Europäisches Patentamt
European Patent Office
Office européen des brevets

(11) **EP 3 001 203 B1**

(12) **EUROPEAN PATENT SPECIFICATION**

(45) Date of publication and mention
of the grant of the patent:
**22.09.2021 Bulletin 2021/38**

(51) Int Cl.:
**G01R 15/16** *(2006.01)*     *G01R 29/16* *(2006.01)*
**H02H 5/10** *(2006.01)*

(21) Application number: **15186628.2**

(22) Date of filing: **24.09.2015**

(54) **SENSOR FOR CONTACTLESS DETECTION OF INTERRUPTED CONDUCTORS IN THREE-PHASE ELETRICAL OVERHEAD LINE AND RELATED METHOD**

**SENSOR ZUR BERÜHRUNGSLOSEN ERKENNUNG VON UNTERBROCHENEN LEITERN IN EINER DREIPHASIGEN ELEKTRISCHEN OVERHEAD-LEITUNG UND ENTSPRECHENDES VERFAHREN**

**CAPTEUR POUR LA DÉTECTION SANS CONTACT D'INTERRUPTION DE CONDUCTEURS DANS UNE LIGNE AÉRIENNE ÉLECTRIQUE TRIPHASÉE ET PROCÉDÉ ASSOCIÉ**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.09.2014 SI 201400330**

(43) Date of publication of application:
**30.03.2016 Bulletin 2016/13**

(73) Proprietor: **E-Senzor d.o.o.**
**2000 Maribor (SI)**

(72) Inventors:
• **BEZJAK, Marjan**
**2000 Maribor (SI)**
• **AMBROZIC, Goran**
**4270 Jesenice (SI)**
• **FINC, Matjaz**
**6310 Izola (SI)**
• **BERTONCELJ, Rafko**
**4245 Kropa (SI)**
• **BEZJAK, Gregor**
**2000 Maribor (SI)**

(74) Representative: **VKK Patentanwälte PartG mbB**
**An der Alster 84**
**20099 Hamburg (DE)**

(56) References cited:
**EP-A1- 0 337 265**     **EP-A2- 2 019 323**
**WO-A2-96/27802**     **FR-A1- 2 782 169**
**JP-A- 2003 156 517**

• **WU L ET AL: "On-site voltage measurement with capacitive sensors on high voltage systems", 2011 IEEE TRONDHEIM POWERTECH : TRONDHEIM, NORWAY, 19 - 23 JUNE 2011, IEEE, PISCATAWAY, NJ, 19 June 2011 (2011-06-19), pages 1-6, XP032263421, DOI: 10.1109/PTC.2011.6019197 ISBN: 978-1-4244-8419-5**
• **SENGER E C ET AL: "BROKEN CONDUCTORS PROTECTION SYSTEM USING CARRIER COMMUNICATION", IEEE TRANSACTIONS ON POWER DELIVERY, IEEE SERVICE CENTER, NEW YORK, NY, US, vol. 15, no. 2, 1 April 2000 (2000-04-01), pages 525-530, XP011049849, ISSN: 0885-8977, DOI: 10.1109/61.852979**

**Description**

**Subject of the Invention**

The subject of the invention is a sensor for contactless detection of interrupted conductors in a three-phase electrical overhead line and a related method, which operates on the basis of measuring electrical field parameters around three-phase overhead lines and enables wireless notification about a fault or interruption of one or more conductors into a remote data centre. The measuring method according to this invention enables simple fault detection and, consequently, a simple construction of a sensor, which functions using at least two electrodes and does not require high precision of individual measurements. The sensor and the method according to this invention are useful for three-phase electrical overhead line networks with different configurations of conductors, e.g. horizontal, triangular, etc.

**Technical Problem**

The technical problem resolved by this invention is a sensor construction installed on a selected electrical pole of an overhead line that will enable efficient and reliable detection of changes in the electrical field surrounding the electricity overhead lines based on a method characteristic of it and it will unambiguously detect a conductor interruption and its location, which will be immediately reported to the data centre. This will result in quick and reliable information concerning the interruption of one, two or all three electric conductors of the electrical overhead lines and the information about the location of the interruption. At the same time, the construction of the sensor will be simple and compact, enabling simple installation onto the electrical poles with the possibility of simply building it into new and already existing electrical poles of the electrical overhead line. The sensor is powered by a high capacity battery for long-term operation.

**Current State of the Art**

The document FR 2 782 169 A1 discloses a sensor for contactless voltage measurement of a three-phase electrical overhead line including a measurement unit with four capacitive electrodes and a logic unit for signal correction in order to get more precise voltage values.

The paper accepted for presentation at the 2011 | EEE Troudheim Power Tech "On-site voltage measurement with capacitive sensors on high voltage systems" of 1. Wu et al. discloses a system with three electrodes which are coupled to three-phase overhead lines respectively and provide a voltage which represents the time derivate of the respective phase voltages. The voltages obtained by the electrodes are then integrated to reconstruct the phase voltages. By monitoring the phase voltages one can detect over voltages. This system does not monitor interrupted conductors.

The document WO 96/237802 A2 discloses a measuring device comprising a horizontally held coil for measuring a current flowing in medium voltage lines.

The article "Broken Conductors Protection System Using Carrier Communication" of Sanger et al. in | EEE Transactions an Power Delivery, Vol. 15, No. 2, April 2000 discloses a single capacitive sensor for detecting waveforms of voltage induced in the sensor.

It is an object of the present invention to present a sensor and a method for precise and prompt detection of interrupted conductors and of fault locations in an observed three-phase electrical overhead line network by contactless detection of these interruptions. In addition to this, the construction of the sensor must be such that its proprietary customized method will enable fast and reliable transmission of information about faults to the relevant remote data center.

**Technical Solution and Description of the Invention**

The technical problem is resolved by a sensor for contactless detection of interrupted conductors in a three-phase electrical overhead line according to claim 1 and by a method according to claim 4.

**Description of the Invention, Theoretical Background and Examples of Usage**

The invention including feasibility examples is more precisely described below, based on figures, which show as follows:

Fig. 1       schematic presentation of the sensor for contactless detection of interrupted conductors in the three-phase electrical overhead line network, with two electrodes
Fig. 2       same as in Fig. 1, but with a single electrode
Fig. 3       feasibility examples of possible constructions of electrodes
Fig. 4       feasibility examples of possible installations of electrodes

Fig. 5     feasibility examples of possible installations of conductors of overhead lines

Fig. 6     schematic presentation of the system with a single electrode

Fig. 7     same as in Fig. 6, but a presentation with the method of substitute capacitances

Fig. 8     scheme of a reference situation with a single electrode

Fig. 9     phasor diagram - $U_1$ failure for the sensor with a single electrode

Fig. 10     phasor diagram - $U_2$ failure for the sensor with a single electrode

Fig. 11     phasor diagram - $U_3$ failure for the sensor with a single electrode

Fig. 12     schematic presentation of the system with two electrodes

Fig. 13     phasor diagram of the system with two electrodes

Fig. 14     phasor diagram - $U_1$ failure for the sensor with two electrodes

Fig. 15     phasor diagram - $U_2$ failure for the sensor with two electrodes

Fig. 16     phasor diagram - $U_3$ failure for the sensor with two electrodes

Fig. 17     graphical presentation of the operation of the system with two electrodes under reference conditions

Fig. 18     same as in Fig. 17, but under the following condition: $U_1 = 0V$

Fig. 19     same as in Fig. 17, but under the following condition: $U_2 = 0V$

Fig. 20     same as in Fig. 17, but under the following condition: $U_1 = U_2 = 0V$

Individual designations in figures indicate:

1 - sensor with two electrodes 4 and 5

2 - sensor with single electrode 4

3 - measurement unit

4 - electrode

5 - electrode

6 - logic unit

7 - communication module

8 - signalling module

9 - battery

10 - conductor of overhead line

11 - conductor of overhead line

12 - conductor of overhead line

13 - holder of electrodes 4 and 5

14 - convex structure

15 - connecting cable between electrodes 4 and/or 5 and the measurement unit 3

16 - electrical pole

17 - holder of conductors 10, 11, 12

18 - isolator

The composition and operation of the claimed sensor 1 with two electrodes 4 and 5, and of the non-claimed sensor 2 with single electrode 4 including the theoretical background of operation and practical application will be separately described below.

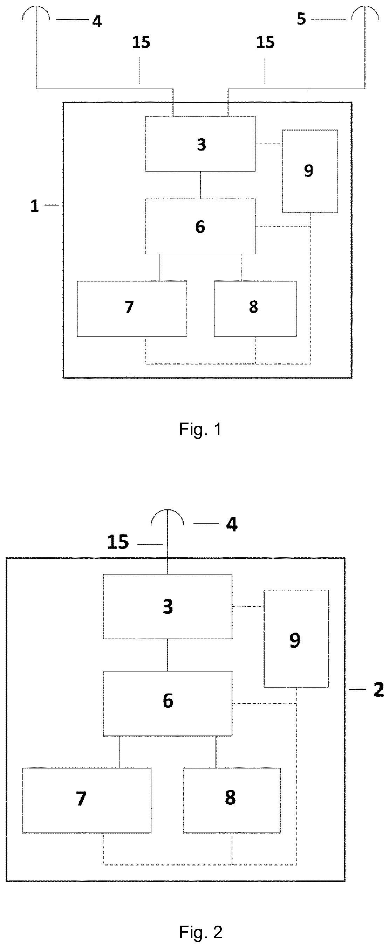

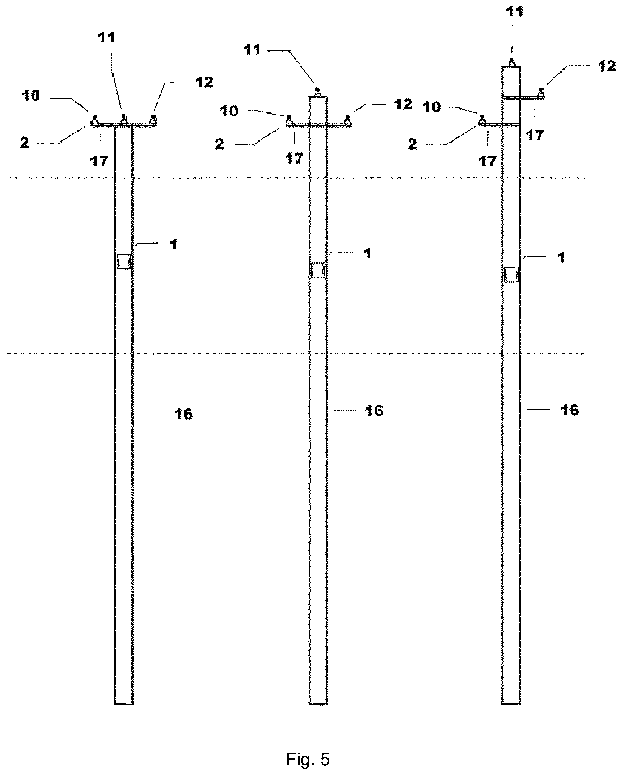

The claimed sensor 1 with two electrodes 4 and 5 is presented in Fig. 1. It consists of the measurement unit 3, the logic unit 6, the communication module 7, the signalling module 8 and the battery 9. The electrodes 4 and 5 are connected to the measurement unit 3 with two connecting cables 15. The logic unit 6 is used for data processing and implements algorithms for detection of interrupted conductors 10 and/or 11 and/or 12 in overhead lines, based on the measurements of changes in the electrical field parameters under the conductors 10, 11 and 12 of overhead lines. The signalling module 8 is used for alarming and signalling the relevant remote data centre. The battery 9 supplies power to the previously mentioned component parts of the sensor 1. The sensor 1 is preferentially mounted in the area suitable for installation on different electricity pillars 16, which is presented in Fig. 5, where it measures the electrical field parameters between the ground and the lowest conductor 10 or 11 or 12 of overhead line. When one, two or three conductors 10 and/or 11 and/or 12 of overhead lines are interrupted, the sensor 1 detects the change in electrical field parameters and based on the use of implemented algorithms, it outputs the indication of the fault or interruption. The fault and the type of fault are signalled locally with the use of the integrated signalling module 8 with built-in light and remotely with the use of the communication module 7 by transmitting a message to the remote data centre, which is not displayed in Fig. 1.

The non-claimed sensor 2, presented in Fig. 2, consists, as previously described sensor 1, of the measurement unit 3, the logic unit 6 for data processing with implemented algorithms for detection of changes, the communication module 7 and the signalling module 8 for alarming and signalling and of battery 7 for power supply. The electrode 4 is connected to the measurement unit 3 with the connecting cable 15.

The sensor 2 is, similarly as the previously described sensor 1, mounted onto the electricity pillars 16, i.e. to the power line poles, between the ground and the lowest conductor 10 or 11 or 12 of overhead line, where it measures the electrical field parameters around the overhead line. When one, two or three conductors 10 and/or 11 and/or 12 of overhead lines are interrupted, the sensor 2 operates and responds as in the previous description of the sensor 1.

The method of sensor 1 operation for the configuration with two electrodes 4 and 5 and of sensor 2 operation for the non-claimed configuration with single electrode 4 is described as follows.

The method of detection of interrupted conductors 10 and/or 11 and/or 12 of overhead lines with sensor 1 according to the invention with two electrodes 4 and 5 is based on measuring the parameters of the electrical field potential on the electrodes 4 and 5 in two locations near the controlled overhead line. The observed parameters, based on which the sensor 1 reliably detects the failure and its type, are the electrical potential amplitudes $V_4$ and $V_5$ in the measured locations and the phase angle $\Delta\varphi$ between these amplitudes. During the symmetry in the three-phase overhead line network, the phase angle $\Delta\varphi$ and the amplitudes $V_4$ and $V_5$ have certain reference values $\Delta\phi_{REF}$ and $V_{REF}$. In case of one interrupted conductor 10, 11 or 12 of overhead lines, the value of the phase angle $\Delta\phi$ decreases, while the amplitudes $V_4$ and $V_5$ increase. In case of two interrupted conductors 10 and 11 or 10 and 12 or 11 and 12 of overhead lines, the value of the phase angle $\Delta\phi$ between the amplitudes $V_4$ and $V_5$ on both electrodes is approximately zero, while the amplitudes $V_4$ and $V_5$ can increase further in case, when the three-phase transformer is connected after the sensor 1. The amplitudes $V_4$ and $V_5$ can also decrease, if the sensor 1 is located at the open end of the overhead line.

In the non-claimed case of a single electrode 4, in the method of detection of interrupted conductors 10 and/or 11 and/or 12 of overhead lines with sensor 2, the sinusoidal electrical field potential is measured on the electrode 4 before the fault and at the event of fault, when the electrical field changes so that the electrical field potential on the electrode 4 keeps the frequency, but it results in the transient phase shift of the sinusoidal electrical field potential with respect to the sinusoidal electrical field potential before the fault. At the same time, the amplitude of the electrical field potential $V_4$ of the sinusoid increases.

The methods of detection of interrupted conductors according to this invention are further described in detail, based on:

- the theoretical description, mathematical equations and diagrams,
- the simulation of the reference condition and faults,
- results of experiments carried out on a controlled test field and on real overhead line network.

*Theory of changes in electrical field near the three-phase overhead line.* In the non-claimed system with sensor 2 and single electrode 4.

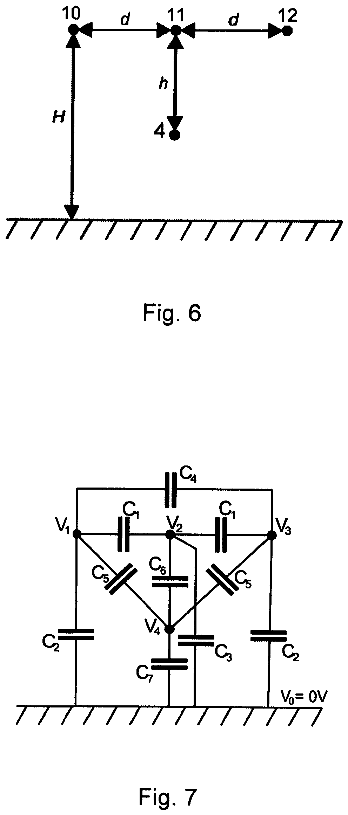

Three conductors 10, 11 and 12 (distance d, height H) with the same properties and geometry are positioned above the grounded base. A small conductive electrode 4 is positioned under the middle conductor 11, at the distance h. The other two designations are distance d and height H. The configuration is presented in Fig. 6.

In view of the symmetry, this configuration can be presented with the method of substitute capacitances as presented in Fig. 7.

When the symmetrical three-phase voltage system $U_1$, $U_2$ and $U_3$ is connected to conductors 10 and/or 11 and/or 12, the following equations can be derived from it:

$$V_4 = K(\eta \cdot \sin\varphi_1 + \sin\varphi_2 + \eta \cdot \sin\varphi_2) \qquad \text{(one)}$$

$$K = \frac{U_g C_6}{2C_5 + C_6 + C_7} \qquad \text{(two)}$$

$$\eta = \frac{C_5}{C_6} \qquad \text{(three)}$$

in which $V_4$ indicates electrical potential on electrode 4, $C_1$ to $C_7$ indicate electric capacitance, $U_g$ refers to the amplitude of the source generator voltage ($U_g = |U_1| = |U_2| = |U_3|$), whereas $\varphi_1$, $\varphi_2$ and $\varphi_3$ refer to the angles between phase voltages $U_1$, $U_2$ and $U_3$ of the three-phase system.

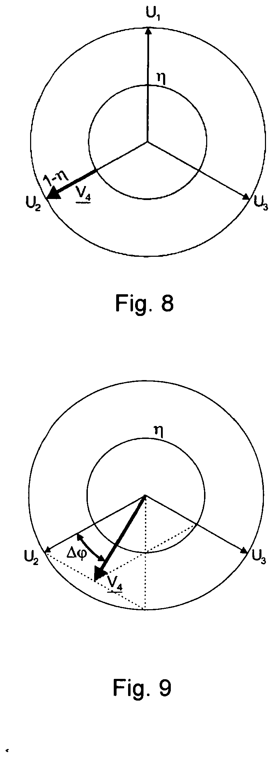

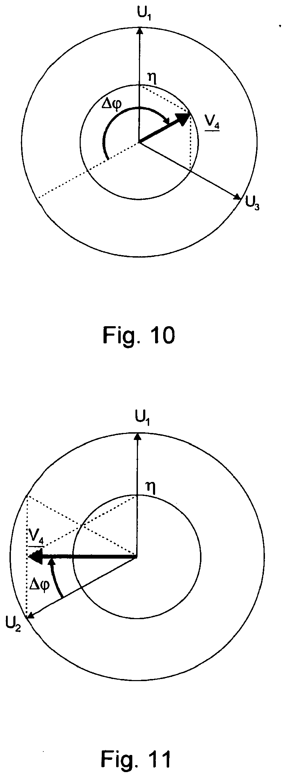

The physical model presented below shows that changes, such as size of generator voltage and geometry of substitute capacitances have a large impact on the amplitude, whereas the phase angle $\varphi$ depends only on the ratio $\eta$ and is independent of the generator voltage. Various scenarios are presented on the phasor diagrams in schemes of diagrams in Figures 8, 9, 10 and 11.

Fig. 8 shows the phasor diagram where all three network voltages $U_1$, $U_2$ and $U_3$ are present, which is the reference condition, resulting in the phasor of the electrical potential $V_4$ on the electrode 4:

$$\underline{V_4} = K((1 - \eta) \cdot \sin\varphi_2) \qquad \text{(four)}$$

Schemes of phasor diagrams in Figures 9, 10 and 11 depict the conditions during single phase faults - $U_1$ or $U_2$ or $U_3$. In case of failure of two phases ($U_1$ and $U_3$) the phasor $\underline{V_4}$ on electrode 4 points in the direction of the uninterrupted phase $U_2$. This indicates that the method enables fault detection based on the detection of phase shift $\Delta\varphi$ of the potential $V_4$, measured on the electrode 4. In case of failures when two conductors 10 and 11 or 10 and 12 or 11 and 12 are interrupted, it may happen that the phase shift $\Delta\varphi$ cannot be detected by measurement because the reference phasor $\underline{V_{4REF}}$ and the measured phasor $\underline{V_4}$ point into the same direction and, consequently, $\Delta\varphi$ does not enable fault detection; therefore, this method must be combined with the method of measuring the amplitude of the potential $V_4$.

An example of the programming procedure of the logic unit 6 with the algorithm for fault detection based on the described method with the combination of the phase shift $\Delta\varphi$ and the measurement of amplitude $V_4$ to be implemented into the logic unit 6 includes the following steps:

Step 1: the initial reference measurement of potential $V_{REF}$ is carried out with the three-phase electrical overhead line under normal operation,

Step 2: the amplitude $V_4$ and phase angle $\varphi$ of the potential on electrode 4 are measured,

Step 3: a fault is indicated if

a. the phase shift is $|\Delta\varphi| > |\Delta\varphi_{threshold}| > 0$
or
b. no amplitude is present ($V_4 \approx 0$)
or
c. the measured amplitude is $V_4 \gg V_{REF}$, e.g. $V_4 > N_V \cdot V_{REF}$
d. return to step 2

The described method can be used for various configurations of electrical overhead lines in the same way, however, the adjustments of the threshold value $\Delta\varphi_{threshold}$ for the detection of the phase shift $|\Delta\varphi| > |\Delta\varphi_{threshold}|$ on electrode 4 are required and the amplitude $V_4 > N_V \cdot V_{4REF}$ must be exceeded. These threshold values can be determined statically as constants or adaptively, with dynamic adjustment, relative to the reference values or as absolute thresholds. Changing the height h of the electrode 4 affects the ratio $\eta$, therefore $\Delta\varphi_{threshold}$ and also the ratio of amplitudes $V_4$ : $V_{4REF}$ change under e.g. reference conditions and faults, which influences the selection of thresholds for detection.

As the phase shift $\Delta\varphi$ is much more independent from external influences, e.g. weather conditions, terrain configuration, etc., the described method for the fault detection according to the invention is more reliable and effective when compared to the known methods that measure only the potential of the amplitude $V_4$.

The claimed system with sensor 1 and two electrodes 4 and 5.

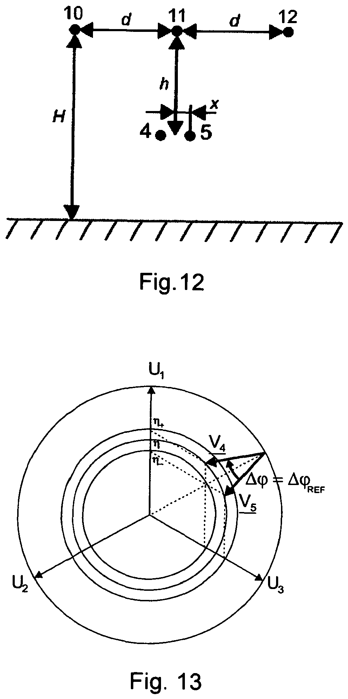

If the previously described physical model is upgraded to two electrodes 4 and 5, which are shifted by distance x from the central line that runs through the middle conductor 11 as presented in Fig. 12, a new model can be developed by using different ratios for the potentials $V_4$ in $V_5$:

$$\underline{V_4} = K(\eta_+ \cdot \sin\varphi_1 + \sin\varphi_2 + \eta_- \cdot \sin\varphi_3) \qquad \text{(five)}$$

$$\underline{V_5} = K(\eta_- \cdot \sin\varphi_1 + \sin\varphi_2 + \eta_+ \cdot \sin\varphi_3) \qquad \text{(six)}$$

In the boundary example, when the distance between electrodes 4 and 5 is equal to zero, we get the situation as in the model with the single electrode - the ratios $\eta_-$ and $\eta_+$ converge to the ratio $\eta$.

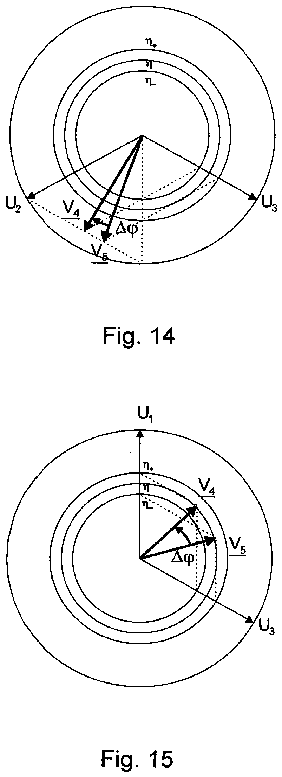

The reference conditions in the electrical overhead line when the voltages $U_1$, $U_2$ and $U_3$ are present in conductors 10, 11, 12 are presented in Fig. 13. Examples of failure of individual conductors 10 or 11 or 12 are presented in in Figures 14, 15 and 16. It is evident from the graphical presentation that the phase difference $\Delta\varphi$ is:

$$\Delta\varphi = \left|\varphi_4 - \varphi_5\right| \qquad \text{(seven)}$$

between the amplitudes $V_4$ and $V_5$ of electrical potentials on electrodes 4 and 5 can be, in case of a certain ratio $\eta$, significantly larger under the reference condition $\Delta\varphi_{REF}$ than during failures. Such deviations from the reference conditions can occur if the conductors 10, 11 and 12 are open at the end of the line and also when the fault in the form of one interrupted phase is modulated through the line network by the transformer, which is positioned on the overhead line after the location of sensor 1. When two conductors 10 and 11 or 10 and 12 or 11 and 12 are down, the amplitudes of potentials $V_4$ and $V_5$ are in-phase, there is no phase difference, so these can be detected simply. The closer the factor $\eta$ is to the value 1, the more significantly larger is the phase difference $\Delta\varphi_{REF}$ under the reference conditions than the phase difference $\Delta\varphi$ in case of faults. As the factor $\eta$ depends upon the geometry or the position of electrodes 4 and 5, it is also possible to define the suitable position of electrodes 4 and 5 by calculation. However, this position must also be empirically adjusted due to the impacts of the construction of sensor 1 and due to various geometries of conductors 10, 11, 12 in the electrical overhead line.

The advantage of the described method is in the fact that faults can be detected only by measuring the phase angle $|\Delta\varphi| < |\Delta\varphi_{REF}|$ and it is not required to include the measurement of amplitudes $V_4$ and $V_5$, except when all the conductors 10 and 11 and 12 are at fault and it is necessary to establish that the voltage is not present.

In this way, detection is performed with a simple algorithm and the fault is indicated if the phase difference $\Delta\varphi$ between the amplitudes $V_4$ and $V_5$ (according to equation seven) is smaller than the threshold value $|\Delta\varphi_{threshold}|$ ($|\Delta\varphi|$ < ($|\Delta\varphi_{threshold}|$). The threshold value $\Delta\varphi_{threshold}$ can be determined statically as a constant or adaptively, with dynamic adjustment, absolutely or relatively, in view of the reference value $\Delta\varphi_{threshold} = N_\phi \cdot \Delta\varphi_{REF}$ with $N_\phi < 1$.

The physical model is easily applied also for other forms of symmetrical and asymmetrical configurations, e.g. for a symmetrical or asymmetrical triangle. but with different ratios K (equation two) and $\eta$ (equation three), which means that electrodes 4 and 5 must be positioned at other points if we wish to detect similar activities.

Simulation of the reference condition and the conditions during faults

To better illustrate the previously presented physical model and results of equations, this model can be presented also in graphical form.

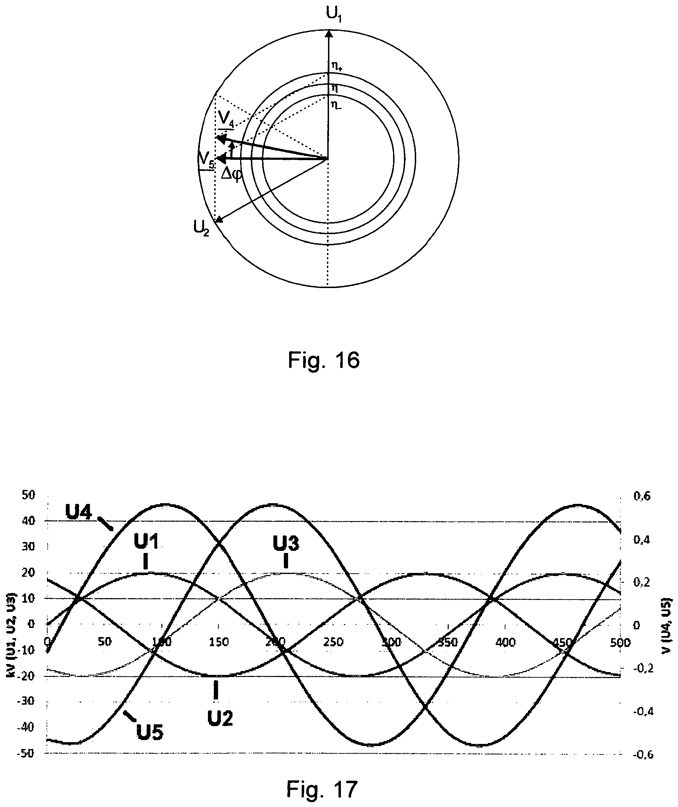

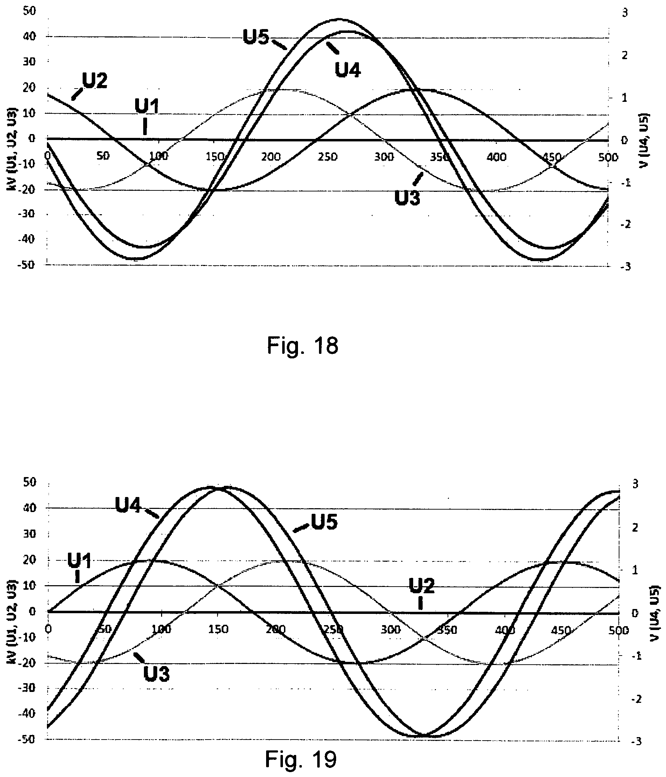

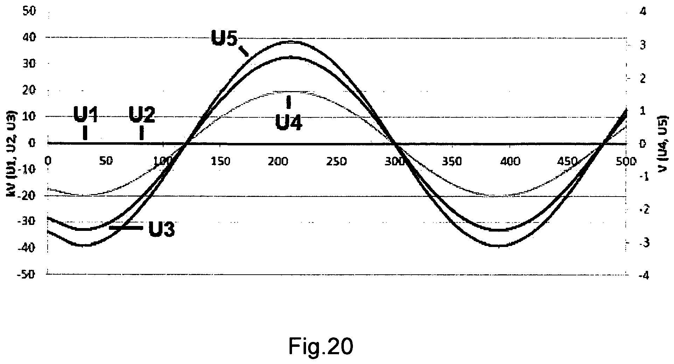

Furthermore, a feasibility example is presented with a system with two electrodes 4 and 5 under three horizontally positioned conductors 10, 11, 12, which are positioned at height H = 8 m, with the distance between them being d = 0.5 mm, whereas two electrodes 4 and 5 under the middle conductor 11-are spaced apart for 2x = 1 m and positioned at height h = 2 m. Various scenarios are presented in Figures 17, 18, 19 and 20. The summary of results is presented in table 1.

Table 1 - summary of simulation under various conditions

| Conditions | $|V_4|$ in $|V_5|$ | $|\Delta\varphi|$ |
|---|---|---|
| $U_1 = U_2 = U_3$ = 11.56 kV | 1 | 92° |
| $U_1$ =0V, $U_2$ =$U_3$ = 11.56 kV | 4.5 | 8° |
| $U_2$ =0V, $U_1$ =$U_3$ = 11.56 kV | 5.1 | 18° |
| $U_1 = U_2$ = 0V, $U_2$ = 11.56 kV | 4.4 | 0° |

The simulation shows that the phase difference $\Delta\varphi$ and the amplitudes $V_4$ and $V_5$ change significantly - as previously predicted by the theoretical physical model.

Below the tests with sensors 1 and 2 and the methods characteristic for them carried out in the test field are presented.

Test results on the controlled medium-voltage test field.

The practical example was carried out on the controlled medium-voltage test field, with voltages 10, 20 and 35 kV. The test field was composed as a controlled replica of the three-phase electrical overhead line network with half-isolated conductors 10, 11, 12. Their maximum height was 5.8 m. The setup enabled different network geometries of conductors 10, 11, 12 - horizontal, triangular, delta position, etc.

The tests were carried out with the sensor 1 with two electrodes 4 and 5, at various voltage levels and for various configurations of conductors 10, 11, 12.

Table 2 - example of results, two electrodes 4 and 5, at phase voltage 11.56 kV

| | | Voltage conditions (presence of individual phases) | | | |
|---|---|---|---|---|---|
| Geometry | Parameter | $U_1 U_2 U_3$ | $U_1 U_2$ | $U_1 U_3$ | $U_2 U_3$ |
| Horizontal | $|\Delta\varphi|$ | 169° | 12° | 49° | 15° |
| | $V_4$ | 34 | 60 | 84 | 81 |
| | $V_5$ | 17 | 59 | 56 | 49 |
| Delta | $|\Delta\varphi|$ | 83° | 27° | 55° | 2° |
| | $V_4$ | 68 | 133 | 185 | 175 |
| | $V_5$ | 39 | 72 | 75 | 61 |
| Triangular | $|\Delta\varphi|$ | 112° | 13° | 60° | 17° |
| | $V_4$ | 70 | 89 | 146 | 136 |
| | $V_5$ | 36 | 76 | 75 | 52 |

Results at 11.56 kV in table 2 indicate that although the electric potentials $V_4$ and $V_5$ on electrodes 4 and 5 increase in case of fault, their amplitude is fairly sensitive to the location and environmental conditions, e.g. terrain configuration, the distance between electrodes 4 and 5, the presence of other buildings in the vicinity, etc. The amplitudes of potentials $V_4$ and $V_5$ on electrodes 4 and 5 change significantly with different network geometry of conductors 10, 11 and 12, i.e. horizontal, triangular or delta. This leads to higher deviation of the measured potential, the threshold between the reference conditions and the faults are less distinct. Fault detection based solely on measuring the amplitudes of the potentials $V_4$ and $V_5$ on electrodes 4 and 5 is possible but many adjustments and calibrations of sensor 1 are required, in view of the to the network geometry, the terrain configuration, etc. On the other hand, the measurements of the phase angle difference $\Delta\varphi$ between the potentials $V_4$ and $V_5$ on electrodes 4 and 5 provide stable and reliable results, regardless of the network geometry of conductors 10, 11 and 12. Similarly, the sensitivity to the terrain configuration and other environmental conditions is fairly reduced.
As the ratio K (equation two) depends on more factors than the ratio $\eta$ (equation three), it is less difficult to adjust the parameter $\eta$.


Tests in real environment

Tests in real environment were carried out on 20 kV MV electrical overhead line. Various constructions of sensors 1 and 2 were tested.
The test of conductor interruption on 20 MV overhead electric line was carried out to test the detection of various types of faults and to test both sensors 1 and 2 in real environment. The interruptions were carried out within time interval of 5 minutes with the purpose to avoid any transients in the electricity grid and to establish stable conditions. The test results of the selected sensor 1 with the open unloaded electrical overhead line and with the same, but the loaded electrical overhead line are presented in Table 3.

Table 3 - test results in real environment

| | Voltage conditions (presence of individual phases) | | | | |
|---|---|---|---|---|---|
| | Open line (unloaded) | | | Loaded line | |
| Parameter | $U_1 U_2 U_3$ | $U_2 U_3$ | $U_3$ | $U_1 U_2 U_3$ | $U_2 U_3$ |
| $|\Delta\varphi|$ | 90° | 10° | 0,2° | 90° | 12° |
| $V_4$ | 320 | 900 | 970 | 320 | 900 |
| $V_5$ | 330 | 900 | 970 | 320 | 900 |

The test results obtained in real environment confirm the theory and findings acquired in the controlled test field. Based on this, various algorithms for detecting interrupted conductors 10 and/or 11 and/or 12 in the electrical overhead line can be implemented.
*An example of an algorithm for detecting interrupted conductors is presented in the table 4 below.*

Table 4 - examples of implemented algorithms, absolute angle considered Constructions of electrodes.

| Algorithm that considers an absolute angle for sensor with the distance between electrodes of 0.2 m or more | | | | |
|---|---|---|---|---|
| Condition on the overhead electric line | All conductors uninterrupted | One conductor interrupted | Two conductors interrupted | All conductors interrupted |
| Phase difference between electrodes | 100% | $80\% \geq |\Delta\varphi| \geq 5\%$ | $|\Delta\varphi| < 5\%$ | No signal |
| Value of potential | 100% | >150% | >150% | < 50% |
| CONDITION | OK | FAULT | | Fault or disconnected conductor |

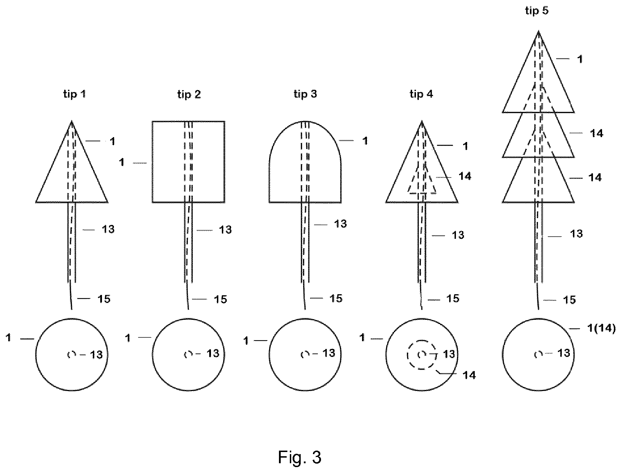

The constructions of electrodes 4 and 5, presented in Fig. 3 and intended for the use with sensor 1 from Fig. 1, ensure that there is no electrical contact between electrodes 4 and 5 under various weather conditions, e.g. rain, frost, snow, etc.

This is ensured with the application of the shape (e.g. hemisphere, cone, cylinder) of electrodes 4 and 5, for which it is typical that their shape is adjusted to climate conditions. The electrodes 4 and 5 are located on the non-conducting holder 13, which is fixed to the electrodes 4 and 5 at the most convex part as shown in Fig. 3. Electrodes 4 and 5 can have several convex structures 14 made of non-conducting material on their bottom side to ensure a better contact interruption. Electrodes 4 and 5 are connected with the measurement unit 3 by means of two connecting cables 15, integrated into the holder 13 of electrodes 4 and/or 5.

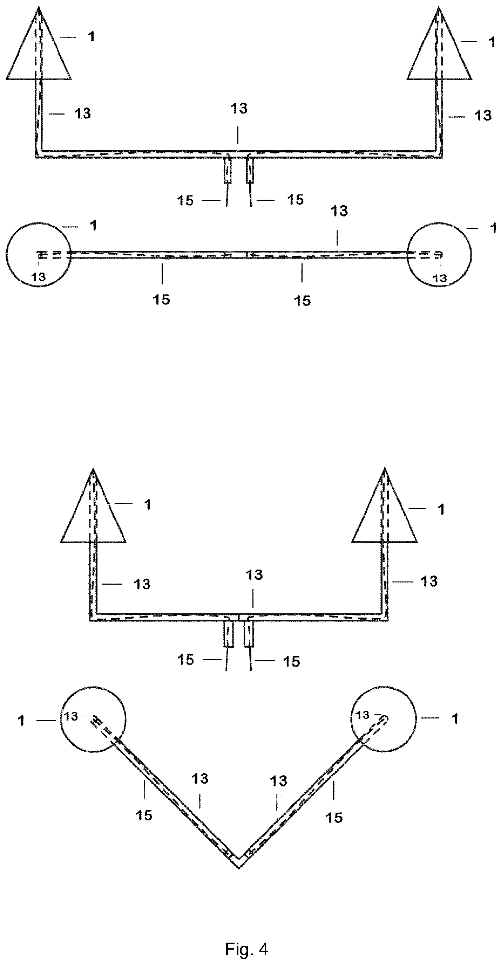

To ensure that there is no electrical contact between electrodes 4 and 5 in various weather conditions, they must be mounted on isolated elongated holders 13. Feasibility examples are presented in Figures 4 and 5.

The implementation of a system with integrated sensor 1 for detecting interrupted conductors 10, 11, 12 and fault current indicator (which is not presented).

Fault current indicators, which measure the magnetic field in the vicinity of conductors 10, 11 and 12 in the electrical overhead line and which, by measuring changes in magnetic field parameters, detect short circuit currents in conductors 10, 11 and 12, represent a technically known solution. These fault current indicators are installed at defined locations on the electrical poles 16 of the electrical overhead line. They are equipped with local signalling and communication module for wireless transmission of messages about faults and fault location to remote data centres.

Due to the structural similarity of fault current indicators for detecting interrupted conductors 10, 11, 12 of electrical overhead line, the integration of a known solution of the fault current indicator and of sensor 1, the subject of this invention, is carried out. The assembly integrated in this way represents a unified device, which consists of the battery 9, the communication module 7, the signalling module 8, two separate measurement units 3 and two logic units 6 with coils for measuring the magnetic field, which is not presented in figures.

The integrated device with sensor 1 and the fault current indicator is positioned on electrical poles 16 of electrical overhead line. It detects interrupted conductors 10, 11 and 12, and transient and permanent short circuit and ground currents and it wirelessly notifies the remote data centre about the fault type and the fault location.

**Claims**

1.  Sensor for contactless detection of interrupted conductors (10, 11, 12) in a three-phase electrical overhead line, comprising a measurement unit (3), a logic unit (6), a communication module (7), a signalling module (8) and a battery (9), **characterised by the fact** that at least one first electrode (4) and at least one further electrode (5) are connected to the measurement unit (3) through corresponding connecting cables (15) and that the electrodes (4, 5) are placed at two points in the vicinity of the electrical overhead line; that the observed parameters, on the basis of which the sensor is configured to determine the interruption and the type of interruption, include phase angle ($\Delta\varphi$) between sinusoids of the electrical potential on the electrodes (4, 5) as well as electrical potential amplitudes ($V_4$, $V_5$) at observed points; wherein, in symmetry, phase angle ($\Delta\varphi$) and amplitudes ($V_4$, $V_5$) have certain reference values ($\Delta\varphi_{REF}$, $V_{REF}$); and, in case of one interrupted conductor (10, 11, 12) the phase angle ($\Delta\varphi$) is reduced, whereas amplitudes ($V_4$, $V_5$) increase; and in case of two interrupted conductors (10 and 11, 10 and 12, 11 and 12), the phase angle ($\Delta\varphi$) between sinusoids of electrical potential on both electrodes (4, 5) is approximately zero, whereas amplitudes ($V_4$, $V_5$) further increase if a three-phase transformer is connected to the electrical overhead line after the sensor (1) or are even slightly reduced if sensor (1) is positioned at the end of an open electrical overhead line.

**2.** Sensor according to claim 1 **characterised by the fact** that the first and further electrodes (4, 5) are in the shape of a hemisphere, cone or cylinder.

**3.** Sensor according to claim 1, **characterised by the fact** that the combination of the change in the phase angle ($\Delta\varphi$) and the change in the electrical potential amplitudes ($V_4$, $V_5$), regarding the condition before the fault, at the occurrence of the fault or after the fault, is used for an algorithm of the sensor (1) for detecting broken conductors (10, 11, 12).

**4.** Method for contactless detection of interrupted conductors (10, 11, 12) in a three-phase electrical overhead line, using the sensor of claim 1, **characterised by the fact** that the sinusoid of the electrical field potential on the first electrode (4) is measured before the fault and at the occurrence of the fault or after the fault when the electrical field changes so that a transient time shift of the sinusoid of the electrical potential occurs in relation to the sinusoid of the electric potential before the fault, also the amplitude ($V_4$) of the sinusoid increases at the same time.

**5.** Sensor according to claim 1 or claim 2, **characterised by the fact** that the sensor (1) is positioned on an electrical pole (16) in the area between the ground and the lowest conductor (10, 11, 12), where the optimal measurement of electrical field parameters round the electrical overhead line is made possible.

**6.** Sensor according to claim 1 or claim 2, **characterised by the fact** that, by integration of a fault current indicator with the sensor (1), an assembled unit is obtained, which includes the battery (9), the communication module (7), the signalling module (8) and two separate measurement units (3) and two separate logic units (6), including coils for measuring the magnetic field.

**7.** Sensor according to claim 6, **characterised by the fact** that the integrated device is mounted on an electrical pole (16) of the electrical overhead line and that it is configured to detect interrupted conductors (10, 11, 12) and a transient and permanent short circuit and ground currents in conductors (10, 11, 12) and to wirelessly notify a remote data centre about the type and location of fault.


**Patentansprüche**

**1.** Sensor zur berührungslosen Erkennung von unterbrochenen Leitern (10, 11, 12) in einer dreiphasigen elektrischen Freileitung, der eine Messeinheit (3), eine Logikeinheit (6), ein Kommunikationsmodul (7), ein Meldemodul (8) und eine Batterie (9) umfasst, **dadurch gekennzeichnet, dass** mindestens eine erste Elektrode (4) und mindestens eine weitere Elektrode (5) über entsprechende Verbindungskabel (15) an die Messeinheit (3) angeschlossen sind und dass die Elektroden (4, 5) an zwei Punkten in der Nähe der elektrischen Freileitung angebracht sind; dass die beobachteten Parameter, anhand derer der Sensor dazu eingerichtet ist, die Unterbrechung und die Art der Unterbrechung zu bestimmen, Phasenwinkel ($\Delta\varphi$) zwischen Sinuskurven des elektrischen Potentials an den Elektroden (4, 5) sowie Amplituden ($V_4$, $V_5$) des elektrischen Potentials an beobachteten Punkten beinhalten; wobei in Symmetrie Phasenwinkel ($\Delta\varphi$) und Amplituden ($V_4$, $V_5$) bestimmte Referenzwerte ($\Delta\varphi_{REF}$, $V_{REF}$) aufweisen; und bei einem unterbrochenen Leiter (10, 11, 12) der Phasenwinkel ($\Delta\varphi$) verringert wird, während die Amplituden ($V_4$, $V_5$) ansteigen; und im Fall von zwei unterbrochenen Leitern (10 und 11, 10 und 12, 11 und 12) der Phasenwinkel ($\Delta\varphi$) zwischen den Sinuskurven des elektrischen Potentials an beiden Elektroden (4, 5) ungefähr Null ist, während die Amplituden ($V_4$, $V_5$) weiter ansteigen, wenn ein Drehstromtransformator hinter dem Sensor (1) an die elektrische Freileitung angeschlossen wird, oder sogar geringfügig verringert werden, wenn der Sensor (1) am Ende einer offenen elektrischen Freileitung positioniert ist.

**2.** Sensor nach Anspruch 1, **dadurch gekennzeichnet, dass** die erste und weitere Elektroden (4, 5) die Form einer Halbkugel, eines Kegels oder eines Zylinders haben.

**3.** Sensor nach Anspruch 1, **dadurch gekennzeichnet, dass** die Kombination aus der Änderung des Phasenwinkels ($\Delta\varphi$) und der Änderung der Amplituden ($V_4$, $V_5$) des elektrischen Potentials, bezogen auf den Zustand vor dem Fehler, beim Auftreten des Fehlers oder nach dem Fehler, für einen Algorithmus des Sensors (1) zur Erkennung von defekten Leitern (10, 11, 12) verwendet wird.

**4.** Verfahren zur berührungslosen Erkennung von unterbrochenen Leitern (10, 11, 12) in einer dreiphasigen elektrischen Freileitung unter Verwendung des Sensors nach Anspruch 1, **dadurch gekennzeichnet, dass** die Sinuskurve des Potentials des elektrischen Feldes an der ersten Elektrode (4) vor dem Fehler und beim Auftreten des Fehlers oder nach dem Fehler bei Änderung des elektrischen Feldes gemessen wird, so dass eine kurzzeitige zeitliche Verschiebung der Sinuskurve des elektrischen Potentials gegenüber der Sinuskurve des elektrischen Potentials vor dem Fehler auftritt, auch die Amplitude ($V_4$) der Sinuskurve gleichzeitig ansteigt.

5. Sensor nach Anspruch 1 oder 2, **dadurch gekennzeichnet, dass** der Sensor (1) an einem Strommast (16) im Bereich zwischen dem Boden und dem untersten Leiter (10, 11, 12) positioniert ist, wo die optimale Messung von Parametern des elektrischen Feldes um die elektrische Freileitung herum ermöglicht wird.

6. Sensor nach Anspruch 1 oder 2, **dadurch gekennzeichnet, dass** durch Integration eines Fehlerstromanzeigers mit dem Sensor (1) eine zusammengebaute Einheit erhalten wird, die die Batterie (9), das Kommunikationsmodul (7), das Meldemodul (8) und zwei getrennte Messeinheiten (3) und zwei getrennte Logikeinheiten (6), einschließlich Spulen zur Messung des Magnetfelds, beinhaltet.

7. Sensor nach Anspruch 6, **dadurch gekennzeichnet, dass** das integrierte Gerät an einem Strommast (16) der elektrischen Freileitung montiert ist und dazu eingerichtet ist, unterbrochene Leiter (10, 11, 12) und einen kurzzeitigen und dauerhaften Kurzschluss und Erdschlussströme in Leitern (10, 11, 12) zu erkennen und ein entferntes Rechenzentrum drahtlos über Art und Ort des Fehlers zu informieren.

## Revendications

1. Capteur pour la détection sans contact de conducteurs (10, 11, 12) interrompus dans une ligne électrique aérienne triphasée, comprenant une unité de mesure (3), une unité logique (6), un module de communication (7), un module de signalisation (8) et une batterie (9), **caractérisé par le fait qu'**au moins une première électrode (4) et qu'au moins une électrode supplémentaire (5) sont connectées à l'unité de mesure (3) par l'intermédiaire de câbles de connexion (15) correspondants et que les électrodes (4, 5) sont placées au niveau de deux points au voisinage de la ligne électrique aérienne ; que les paramètres observés, sur la base desquels le capteur est configuré pour déterminer l'interruption et le type d'interruption, comprennent un angle de phase ($\Delta\varphi$) entre les sinusoïdes du potentiel électrique sur les électrodes (4, 5) ainsi que les amplitudes ($V_4$, $V_5$) de potentiel électrique au niveau des points observés ; dans lequel, en symétrie, l'angle de phase ($\Delta\varphi$) et les amplitudes ($V_4$, $V_5$) présentent certaines valeurs de référence ($\Delta\varphi_{REF}$, $V_{REF}$) ; et, dans le cas d'un conducteur (10, 11, 12) interrompu, l'angle de phase ($\Delta\varphi$) est réduit, tandis que les amplitudes ($V_4$, $V_5$) augmentent ; et dans le cas de deux conducteurs (10 et 11, 10 et 12, 11 et 12) interrompus, l'angle de phase ($\Delta\varphi$) entre les sinusoïdes de potentiel électrique sur les deux électrodes (4, 5) est approximativement nul, tandis que les amplitudes ($V_4$, $V_5$) augmentent davantage si un transformateur triphasé est connecté à la ligne électrique aérienne après le capteur (1) ou sont même légèrement réduites si le capteur (1) est positionné à l'extrémité d'une ligne électrique aérienne ouverte.

2. Capteur selon la revendication 1, **caractérisé par le fait que** la première électrode (4) et l'électrode supplémentaire (5) sont sous la forme d'une demi-sphère, d'un cône ou d'un cylindre.

3. Capteur selon la revendication 1, **caractérisé par le fait que** la combinaison du changement de l'angle de phase ($\Delta\varphi$) et du changement des amplitudes ($V_4$, $V_5$) de potentiel électrique, concernant l'état avant le défaut, à l'apparition du défaut ou après le défaut, est utilisée pour un algorithme du capteur (1) pour détecter des conducteurs (10, 11, 12) cassés.

4. Procédé de détection sans contact de conducteurs (10, 11, 12) interrompus dans une ligne électrique aérienne triphasée, utilisant le capteur selon la revendication 1, **caractérisé par le fait que** la sinusoïde du potentiel de champ électrique sur la première électrode (4) est mesurée avant le défaut et à l'apparition du défaut ou après le défaut quand le champ électrique change de sorte qu'un décalage temporel transitoire de la sinusoïde du potentiel électrique se produit par rapport à la sinusoïde du potentiel électrique avant le défaut, également l'amplitude ($V_4$) de la sinusoïde augmente en même temps.

5. Capteur selon la revendication 1 ou la revendication 2, **caractérisé par le fait que** le capteur (1) est positionné sur un poteau électrique (16) dans la zone entre le sol et le conducteur (10, 11, 12) le plus bas, où la mesure optimale des paramètres de champ électrique autour de la ligne électrique aérienne est rendue possible.

6. Capteur selon la revendication 1 ou la revendication 2, **caractérisé par le fait que**, par intégration d'un indicateur de courant de défaut avec le capteur (1), une unité assemblée est obtenue, qui comprend la batterie (9), le module de communication (7), le module de signalisation (8) et deux unités de mesure (3) séparées et deux unités logiques (6) séparées, comprenant des bobines pour mesurer le champ magnétique.

7. Capteur selon la revendication 6, **caractérisé par le fait que** le dispositif intégré est monté sur un poteau électrique (16) de la ligne électrique aérienne et qu'il est configuré pour détecter des conducteurs (10, 11, 12) interrompus et un court-circuit transitoire et permanent et des courants à la terre dans des conducteurs (10, 11, 12) et pour notifier sans fil à un centre de données distant le type et l'emplacement du défaut.

**Fig. 1**

**Fig. 2**

Fig. 3

1 — 1

13 — 13      13      1 — 13

15 — 15      15

1 — 1      13      1 — 1

13      15      15      13

1 — 1

13 — 13      13      1 — 13

15 — 15      15

1 — 13      13 — 1

13      13

15      15

Fig. 4

Fig. 5

Fig. 6

Fig. 7

Fig. 8

Fig. 9

Fig. 10

Fig. 11

Fig.12

Fig. 13

Fig. 14

Fig. 15

Fig. 16

Fig. 17

Fig. 18

Fig. 19

Fig.20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2782169 A1

- WO 96237802 A2


**Non-patent literature cited in the description**

- **WU.** On-site voltage measurement with capacitive sensors on high voltage systems. *EEE Troudheim Power Tech,* 2011

- **SANGER et al.** Broken Conductors Protection System Using Carrier Communication. *EEE Transactions an Power Delivery,* April 2000, vol. 15 (2